(19) Europäisches Patentamt
European Patent Office
Office européen des brevets

(11) **EP 1 126 546 A2**

(12) **EUROPÄISCHE PATENTANMELDUNG**

(43) Veröffentlichungstag:
22.08.2001 Patentblatt 2001/34

(51) Int Cl.7: **H01R 4/02**

(21) Anmeldenummer: 01101017.0

(22) Anmeldetag: 18.01.2001

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: 15.02.2000 DE 10006764

(71) Anmelder: Heraeus Electro-Nite International N.V.
3530 Houthalen (BE)

(72) Erfinder:
• **Cappa, Guido**
  **3530 Houthalen (BE)**
• **van Geloven, Peter, Dr.**
  **3221 Holsbek (BE)**

(74) Vertreter: **Kühn, Hans-Christian**
**Heraeus Holding GmbH,**
**Schutzrechte,**
**Heraeusstrasse 12-14**
**63450 Hanau (DE)**

(54) **Elektrische Verbindung**

(57) Die Erfindung betrifft eine elektrische Verbindung eines elektrischen bandförmigen Leiters mit einer auf einem keramischen Substrat angeordneten, Edelmetall aufweisenden Kontaktschicht, wobei die Dicke der Kontaktschicht geringer ist als die Dicke des bandförmigen Leiters. Es stellt sich das Problem, eine die Nachteile des Standes der Technik vermeidende elektrische Verbindung und ein kostengünstiges Verfahren zu deren Herstellung bereitzustellen. Das Problem wird für die elektrische Verbindung dadurch gelöst, dass der bandförmige Leiter mindestens zwei Schichten unterschiedlicher Dicke und unterschiedlicher elektrischer spezifischer Widerstände aufweist und dass eine der Kontaktschicht zugewandte erste Schicht im Hinblick auf die weiteren Schichten ein Material mit dem niedrigsten elektrischen spezifischen Widerstand aufweist und dass die elektrische Verbindung zwischen dem bandförmigen Leiter und der Kontaktschicht mittels Spaltschweißen gebildet ist. Ein besonderer Vorteil ist dabei, dass die Gesamtdicke des bandförmigen Leiters, der auch drahtförmig ausgebildet sein kann, die Schweißbarkeit dabei kaum beeinflusst.

Fig. 1

**Beschreibung**

Die Erfindung betrifft eine elektrische Verbindung eines elektrischen bandförmigen Leiters mit einer auf einem keramischen Substrat angeordneten, Edelmetall aufweisenden Kontaktschicht, wobei die Dicke der Kontaktschicht geringer ist als die Dicke des bandförmigen Leiters.

Das Anbringen eines band- oder drahtförmigen elektrischen Leiters auf einer Edelmetall aufweisenden Kontaktschicht erfolgt üblicherweise durch Schweißen. Der elektrische Leiter selbst besteht meist, vor allem bei einer Anwendung der elektrischen Verbindung bei hohen Temperaturen, aus oxidationsbeständigem Edelmetall oder einer Edelmetall-Legierung. Das Edelmetall gewährleistet einen hohen Stromfluss während des Schweißvorganges und damit die Ausbildung einer elektrischen Verbindung hoher Festigkeit.

Die US 5,306,891 beschreibt eine Verbindung zwischen einem Metallband und einem Schweißpad auf einem keramischen Substrat. Das Schweißpad besteht aus einer Wolframschicht, welche auf das noch grüne keramische Substrat aufgedruckt wird. Die Wolframschicht wird zusammen mit dem keramischen Substrat gesintert und eingebrannt. Die eingebrannte Wolframschicht wird anschließend mit einer oder mehreren Dünnschichten überzogen, wobei die oberste Dünnschicht aus Gold gebildet ist. Das Metallband, das einen niedrigeren Schmelzpunkt als Wolfram aufweist und vorzugsweise aus einer Kupferlegierung gebildet ist, wird mittels Laserschweißen mit dem Kontaktpad verbunden. Dabei werden nur die Dünnschichten des Kontaktpads mit den Metallband verschmolzen, nicht aber die Wolframschicht.

So wird vermieden, dass die bei der Verbindung eines Metallbandes mit einem Kontaktpad auf einem keramischen Substrat an den Schweißpunkten auftretenden thermischen Belastungen zu Mikrorissen im Kontaktpad oder im keramischen Substrat führen, die bei einem späteren Einsatz der Verbindung bei hohen Temperaturen zu einer Ablösung des Kontakts führen könnten.

Allerdings ist die Herstellung des mehrschichtigen Schweißpads aufwendig. Zudem erfordern die Herstellung der Dünnschichten und das Laserschweißen teure und aufwendige Anlagen.

Es stellt sich das Problem, eine die Nachteile des Standes der Technik vermeidende elektrische Verbindung und ein kostengünstiges Verfahren zu deren Herstellung bereitzustellen.

Das Problem wird für die elektrische Verbindung dadurch gelöst, dass der bandförmige Leiter mindestens zwei Schichten unterschiedlicher Dicke und unterschiedlicher elektrischer spezifischer Widerstände aufweist und dass eine der Kontaktschicht zugewandte erste Schicht im Hinblick auf die weiteren Schichten ein Material mit dem niedrigsten elektrischen spezifischen Widerstand aufweist und dass die elektrische Verbindung zwischen dem bandförmigen Leiter und der Kontaktschicht mittels Spaltschweißen gebildet ist. Ein besonderer Vorteil ist dabei, dass die Gesamtdicke des bandförmigen Leiters, der auch drahtförmig ausgebildet sein kann, die Schweißbarkeit dabei kaum beeinflusst.

Der bandförmige Leiter, der eine Anzahl an Schichten n ≥ 2 aufweist, eine Ausbildung der Schichten sowie eine Anordnung und Ausbildung der Schweißelektroden folgen den Gleichungen

$$(1)\quad 2 * \sum_{i=2}^{n} \frac{\rho_i * d_i}{k} + \frac{\rho_1 * L}{d_1} = m \cdot R_{2\equiv n}$$

$$(2)\quad R_{2\equiv 2} = \frac{\rho_2 * L}{d_2} \qquad \text{für } n = 2$$

$$(3)\quad R_{2\equiv n} = \left(\left(\frac{\rho_n * L}{d_n}\right)^{-1} + \left(\frac{2 * \rho_n * d_n}{k} + R_{2\equiv (n-1)}\right)^{-1}\right)^{-1} \qquad \text{für } n > 2$$

wobei m eine Zahl im Bereich von 0 bis 10 ist, mit

L = Abstand zwischen den Schweißelektroden,
k = Breite der Schweißelektroden, wobei die Schweißelektroden eine Länge von 1 aufweisen,
$\rho_1$ = elektrischer spezifischer Widerstand der ersten Schicht,
$\rho_n$ = elektrischer spezifischer Widerstand der n-ten Schicht,
$d_1$ = Dicke der ersten Schicht,
$d_n$ = Dicke der n-ten Schicht
$R_{2\equiv n}$ = elektrischer Widerstand der Schichten 2 bis n, gemessen zwischen den Schweißelektroden.

$R_{2\equiv n}$ wird bestimmt, indem gedanklich die erste, der Kontaktschicht zugewandte Schicht entfernt und gegen einen Isolator ersetzt wird. Der nun zwischen den Schweißelektroden mit den Einstellungen k und L ( und einer Andruckkraft der Schweißelektroden wie beim Schweißvorgang ) über die Schichten 2 bis n messbare elektrische Widerstand entspricht dem Wert $R_{2\equiv n}$. Besonders vorteilhaft ist es, wenn der bandförmige Leiter eine erste Schicht und eine zweite Schicht aufweist ( n = 2 ) und eine Ausbildung der Schichten sowie eine Anordnung und Ausbildung der Schweißelektroden den Gleichungen

$$\text{(1a)} \quad 2 * \sum_{i=2}^{2} \frac{\rho_i * d_i}{k} + \frac{\rho_1 * L}{d_1} = m \cdot R_{2\equiv 2}$$

$$\text{(2)} \quad R_{2\equiv 2} = \frac{\rho_2 * L}{d_2}$$

$$\text{(4)} \quad \frac{2 * d_2^{\,2}}{L * k} + \frac{\rho_1 * d_2}{\rho_2 * d_1} = m$$

folgen, wobei m eine Zahl im Bereich von 0 bis 10 ist, mit

    L = Abstand zwischen den Schweißelektroden,
    k = Breite der Schweißelektroden, wobei die Schweißelektroden eine Länge von 1 aufweisen,
    $\rho_1$ = elektrischer spezifischer Widerstand der ersten Schicht,
    $\rho_2$ = elektrischer spezifischer Widerstand der zweiten Schicht,
    $d_1$ = Dicke der ersten Schicht,
    $d_2$ = Dicke der zweiten Schicht
    $R_{2\equiv 2}$ = elektrischer Widerstand der Schicht 2, gemessen zwischen den Schweißelektroden.

Besonders vorteilhaft ist es aber auch, wenn der bandförmige Leiter eine erste, eine zweite und eine dritte Schicht aufweist ( n = 3 ) und eine Ausbildung der Schichten sowie eine Anordnung und Ausbildung der Schweißelektroden den Gleichungen

$$\text{(1b)} \quad 2 * \sum_{i=2}^{3} \frac{\rho_i * d_i}{k} + \frac{\rho_1 * L}{d_1} = m \cdot R_{2\equiv 3}$$

$$\text{(3a)} \quad R_{2\equiv 3} = \left( \left( \frac{\rho_3 * L}{d_3} \right)^{-1} + \left( \frac{2 * \rho_3 * d_3}{k} + R_{2\equiv 2} \right)^{-1} \right)^{-1}$$

folgen, wobei m eine Zahl im Bereich von 0 bis 10 ist, mit

    L = Abstand zwischen den Schweißelektroden,
    k = Breite der Schweißelektroden, wobei die Schweißelektroden eine Länge von 1 aufweisen,
    $\rho_1$ = elektrischer spezifischer Widerstand der ersten Schicht,
    $\rho_2$ = elektrischer spezifischer Widerstand der zweiten Schicht,
    $\rho_3$ = elektrischer spezifischer Widerstand der dritten Schicht,
    $d_1$ = Dicke der ersten Schicht,
    $d_2$ = Dicke der zweiten Schicht,
    $d_3$ = Dicke der dritten Schicht,
    $R_{2\equiv 3}$ = elektrischer Widerstand der Schichten 2 bis 3, gemessen zwischen den Schweißelektroden.

Vorteilhaft ist es außerdem, wenn der bandförmige Leiter eine erste, eine zweite, eine dritte und eine vierte Schicht aufweist ( n = 4 ) und eine Ausbildung der Schichten sowie eine Anordnung und Ausbildung der Schweißelektroden den Gleichungen

$$(1c) \quad 2 * \sum_{i=2}^{4} \frac{\rho_i * d_i}{k} + \frac{\rho_1 * L}{d_1} = m \cdot R_{2\equiv4}$$

$$(3b) \quad R_{2\equiv4} = \left(\left(\frac{\rho_4 * L}{d_4}\right)^{-1} + \left(\frac{2 * \rho_4 * d_4}{k} + R_{2\equiv3}\right)^{-1}\right)^{-1}$$

folgen, wobei m eine Zahl im Bereich von 0 bis 10 ist, mit

L = Abstand zwischen den Schweißelektroden,
k = Breite der Schweißelektroden, wobei die Schweißelektroden eine Länge von 1 aufweisen,
$\rho_1$ = elektrischer spezifischer Widerstand der ersten Schicht,
$\rho_2$ = elektrischer spezifischer Widerstand der zweiten Schicht,
$\rho_3$ = elektrischer spezifischer Widerstand der dritten Schicht,
$\rho_4$ = elektrischer spezifischer Widerstand der vierten Schicht,
$d_1$ = Dicke der ersten Schicht,
$d_2$ = Dicke der zweiten Schicht
$d_3$ = Dicke der dritten Schicht,
$d_4$ = Dicke der vierten Schicht
$R_{2\equiv4}$ = elektrischer Widerstand der Schichten 2 bis 4, gemessen zwischen den Schweißelektroden.

Idealerweise ist m jedoch eine Zahl im Bereich von 0 bis 1. Dadurch wird erreicht, dass der Schweißstrom hauptsächlich durch die erste Schicht fließt. Ein Verhältnis der Dicken zwischen der ersten Schicht und der Summe der weiteren Schichten sollte insbesondere im Bereich 1:1,1 bis 1:30 gebildet sein und vorzugsweise 1:10 betragen. Von Vorteil ist es, wenn die weiteren Schichten jeweils einen um den Faktor 2 bis 10 höheren elektrischen spezifischen Widerstand aufweisen als die erste Schicht. Bewährt hat sich vor allem der Faktor 3.

Die erste Schicht ist vorteilhafterweise aus einem Edelmetall oder einer Edelmetall-Legierung gebildet. Die Verwendung von Gold oder Silber oder Kupfer oder einer mindestens eines dieser Elemente umfassenden niederohmigen Legierung hat sich bewährt. Mindestens eine der weiteren Schichten kann aus temperaturbeständigem Edelstahl oder Nickel oder einer hochohmigen Nickel-Legierung gebildet sein, wobei vor allem Kupfer-Nickel-Legierungen, Edelstähle der Klassen 1.4762 oder 1.4828 oder 1.4841, Inconel 600 oder Inconel 601 in Frage kommen.

Das Problem wird für das Verfahren dadurch gelöst, dass

a) der elektrische bandförmige Leiter der Dicke D mit der ersten Schicht auf die Kontaktschicht aufgelegt wird, und dass
b) zwei Schweißelektroden jeweils mit der Breite k und der Länge 1 in einem Abstand L zwischen den Schweißelektroden zueinander parallel angeordnet werden, und dass
c) die zwei Schweißelektroden in Höhe der Kontaktschicht gleichzeitig auf der Seite des bandförmigen Leiters aufgesetzt werden, die der ersten Schicht abgewandt ist, und dass
d) zwischen den zwei Schweißelektroden ein elektrischer Strom erzeugt wird, und dass
e) der elektrische Strom ausgehend von einer Schweißelektrode im wesentlichen einen Pfad wählt, der zuerst senkrecht gerichtet bis zum Erreichen der ersten Schicht verläuft, anschließend horizontal in Höhe der ersten Schicht und schließlich wieder senkrecht gerichtet in Richtung der anderen Schweißelektrode verläuft, und dass
f) dadurch eine Schweißverbindung zwischen der ersten Schicht und der Kontaktschicht erzeugt wird.

Der im wesentlichen in Nähe der ersten Schicht des bandförmigen Leiter und der Kontaktschicht fließende elektrische Strom führt bei einer relativ niedrigen benötigten Schweißleistung zu einer Verbindung hoher Festigkeit und hoher elektrischer Leitfähigkeit. Die niedrige Schweißleistung führt zu einer geringeren thermischen Belastung der Kontaktschicht und des keramischen Substrates und damit zu weniger beziehungsweise keinen Mikrorissen, die die Festigkeit der Verbindung bei hohen Temperaturen oder Temperaturzyklen beeinträchtigen könnten.

Der Abstand L zwischen den Schweißelektroden sollte dabei mindestens doppelt so groß wie die Gesamtdicke D des bandförmigen Leiters sein.

Während des Schweißens kann entweder der elektrische Strom oder die elektrische Spannung oder die elektrische Leistung konstant gehalten werden.

Die elektrische Verbindung ist zur Verwendung für den Anschluss eines Sensors in einem Kraftfahrzeug, insbesondere eines thermisch belasteten Sensors in der Abgasführung des Kraftfahrzeuges, geeignet.

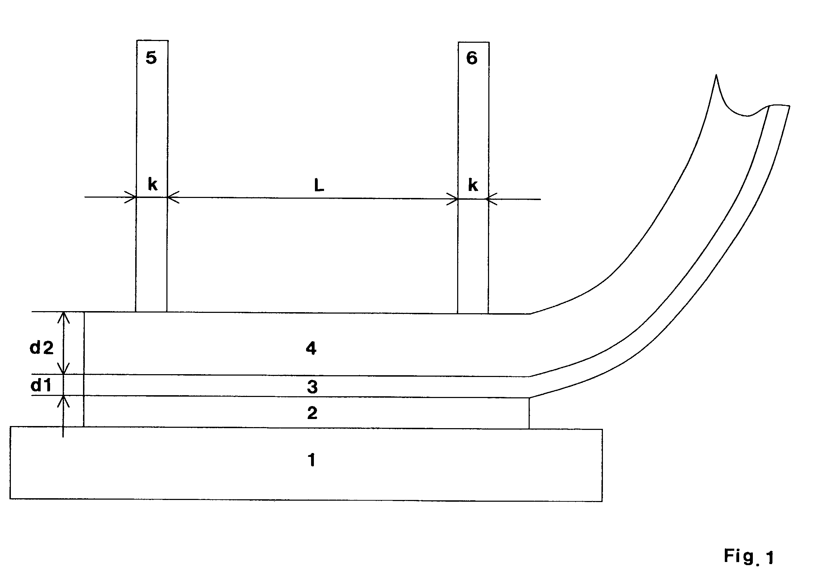

Folgende drei Beispiele und Figur 1 sollen die Erfindung beispielhaft näher erläutern.

Bsp 1:   Elektrische Verbindung einer Au-Kontaktschicht mit einem zweischichtigen bandförmigen Leiter, der eine erste, 20µm dicke Schicht aus Au und eine zweite Schicht aus Ni aufweist

Bsp. 2:   : Elektrische Verbindung einer Au-Kontaktschicht mit einem zweischichtigen bandförmigen Leiter, der eine erste, 5µm dicke Schicht aus Au und eine zweite Schicht aus Ni aufweist

Bsp. 3:   : Elektrische Verbindung einer Au-Kontaktschicht mit einem zweischichtigen bandförmigen Leiter, der eine erste, 5µm dicke Schicht aus Au und eine zweite Schicht aus Ti aufweist

Bsp. 4:   Elektrische Verbindung einer Ag-Kontaktschicht mit einem dreischichtigen bandförmigen Leiter, der eine erste, 10µm dicke Schicht aus Ag aufweist

Fig. 1:   Elektrische Verbindung einer Kontaktschicht mit einem zweischichtigen bandförmigen Leiter und entsprechende Anordnung der Schweißelektroden

Beispiel 1:

Ein zweischichtiger bandförmiger Leiter der Gesamtdicke D = 75µm mit einer ersten Schicht aus Au in einer Dicke $d_1$ = 20µm und einer zweiten Schicht aus Ni in einer Dicke $d_2$ = 55µm wird auf eine siebgedruckte, eingebrannte Kontaktschicht aus Au geschweißt. Der elektrische spezifische Widerstand der Au-Schicht des bandförmigen Leiters beträgt $\rho_1$ = 23∗10⁻⁹ Ωm und der der Ni-Schicht $\rho_2$ = 68∗10⁻⁹ Ωm. Bei einer Breite k = 0.5mm der Schweißelektroden, deren Länge gleich 1mm angenommen ist, und einem gewählten Abstand L = 1mm zwischen den Schweißelektroden ergibt sich

$$\frac{2 * d_2^2}{L * k} + \frac{\rho_1 * d_2}{\rho_2 * d_1} = \frac{2 * (55\mu m)^2}{1mm * 0.5mm} + \frac{23 * 10^{-9}\Omega m * 55\ \mu m}{68 * 10^{-9}\Omega m * 20\mu m} = 0{,}94 = m$$

und mit m = 0,94 eine hervorragend schweißbare elektrische Verbindung hoher Festigkeit und hoher elektrischer Leitfähigkeit.

Beispiel 2:

Ein zweischichtiger bandförmiger Leiter der Gesamtdicke D = 75µm mit einer ersten Schicht aus Au in einer Dicke $d_1$ = 5µm und einer zweiten Schicht aus Ni in einer Dicke $d_2$ = 70µm wird auf eine siebgedruckte, eingebrannte Kontaktschicht aus Au geschweißt. Der elektrische spezifische Widerstand der Au-Schicht des bandförmigen Leiters beträgt $\rho_1$ = 23.10⁻⁹ Ωm und der der Ni-Schicht $\rho_2$ = 68∗10⁻⁹ Ωm. Bei einer Breite k = 0.5mm der Schweißelektroden, deren Länge gleich 1mm angenommen ist, und einem gewählten Abstand L = 0.2mm zwischen den Schweißelektroden ergibt sich

$$\frac{2 * d_2^2}{L * k} + \frac{\rho_1 * d_2}{\rho_2 * d_1} = \frac{2 * (70\mu m)^2}{0.2mm * 0.5mm} + \frac{23 * 10^{-9}\Omega m * 70\mu m}{68 * 10^{-9}\Omega m * 5\mu m} = 4{,}83 = m$$

und mit m = 4,83 eine etwas schlechter schweißbare aber kostengünstigere elektrische Verbindung als die des Beispieles 1. Im Vergleich zu einem bandförmigen Leiter, der nur aus Nickel gebildet ist, ist die Schweißbarkeit dennoch erheblich verbessert und die Gefahr eines Auftretens von Mikrorissen deutlich niedriger.

Beispiel 3:

Ein zweischichtiger bandförmiger Leiter der Gesamtdicke D = 75µm mit einer ersten Schicht aus Au in einer Dicke $d_1$ = 5µm und einer zweiten Schicht aus Ti in einer Dicke $d_2$ = 70µm wird auf eine siebgedruckte, eingebrannte Kontaktschicht aus Au geschweißt. Der elektrische spezifische Widerstand der Au-Schicht des bandförmigen Leiters beträgt $\rho_1$ = 23∗10⁻⁹ Ωm und der der Ti-Schicht $\rho_2$ = 430∗10⁻⁹ Ωm. Bei einer Breite k = 0.5mm der Schweißelektroden, deren Länge gleich 1mm angenommen ist, und einem gewählten Abstand L = 0.2mm zwischen den Schweißelektroden ergibt sich

$$\frac{2 * d_2^2}{L * k} + \frac{\rho_1 * d_2}{\rho_2 * d_1} = \frac{2 * (70\mu m)^2}{0.2mm * 0.5mm} + \frac{23 * 10^{-9}\Omega m * 70\mu m}{430 * 10^{-9}\Omega m * 5\mu m} = 0.85 = m$$

und mit m = 0.85 eine hervorragend schweißbare elektrische Verbindung. Allerdings besitzt Titan die Eigenschaft, bei hohen Temperaturen spröde zu werden.

Beispiel 4:

Ein dreischichtiger bandförmiger Leiter der Gesamtdicke D = 85µm mit einer ersten Schicht aus Ag in einer Dicke $d_1$ = 10µm und einer zweiten Schicht aus Ni in einer Dicke $d_2$ = 5µm und einer dritten Schicht aus RVS302 in einer Dicke $d_3$ = 70µm wird auf eine siebgedruckte Kontaktschicht aus Ag geschweißt. Der elektrische spezifische Widerstand der Ag-Schicht des bandförmigen Leiters beträgt pi = $16.10^{-9}$ Ωm, der der Ni-Schicht $\rho_2$ = $70 * 10^{-9}$ Ωm und der der RVS302 -Schicht $\rho_3$ = $765 * 10^{-9}$ Ωm. Bei einer Breite k = 0,5mm der Schweißelektroden, deren Länge gleich 1mm angenommen ist, und einem gewählten Abstand L = 0,2mm zwischen den Schweißelektroden ergibt sich

$$2 * \sum_{i=2}^{3} \frac{\rho_i * d_i}{k} + \frac{\rho_1 * L}{d_1} = m \cdot R_{2=3}$$

$$2 * \sum_{i=2}^{3} \frac{\rho_i * d_i}{k} + \frac{\rho_1 * L}{d_1} =$$

$$= 2 * \left( \frac{70 * 10^{-9}\,\Omega m * 5 * 10^{-6}\,m}{0,5 * 10^{-3}\,m} + \frac{765 * 10^{-9}\,\Omega m * 70 * 10^{-6}\,m}{0,5 * 10^{-3}\,m} \right) + \frac{16 * 10^{-9}\,\Omega m * 0,2 * 10^{-3}\,m}{10 * 10^{-6}\,m} =$$

$$= 5,35 \cdot 10^{-7}\,\Omega m$$

$$R_{2=2} = \frac{\rho_2 * L}{d_2} = \frac{70 * 10^{-9}\,\Omega m * 0,2 * 10^{-3}\,m}{5 * 10^{-6}\,m}$$

$$R_{2=3} = \left( \left( \frac{\rho_3 * L}{d_3} \right)^{-1} + \left( \frac{2 * \rho_3 * d_3}{k} + R_{2=2} \right)^{-1} \right)^{-1} =$$

$$= \left( \left( \frac{765 * 10^{-9}\,\Omega m * 0,2 * 10^{-3}\,m}{70 * 10^{-6}\,m} \right)^{-1} + \left( \frac{2 * 765 * 10^{-9}\,\Omega m * 70 * 10^{-6}\,m}{0,5 * 10^{-3}\,m} + R_{2=2} \right)^{-1} \right)^{-1} =$$

$$= 1,26 \cdot 10^{-6}\,\Omega m$$

$$m = \frac{5,35 * 10^{-7}\,\Omega m}{1,26 * 10^{-6}\,\Omega m} = 0,4$$

und mit m = 0.4 eine hervorragend schweißbare elektrische Verbindung.
Fig. 1 zeigt ein keramisches Substrat 1 mit einer Kontaktschicht 2 und einen zweischichtigen, elektrischen bandförmigen Leiter mit einer ersten Schicht 3 und einer zweiten Schicht 4. Die Dicke der ersten Schicht 3 beträgt d1 und die Dicke der zweiten Schicht d2. Die Schweißelektroden 5; 6 mit jeweils einer Breite k werden zur Herstellung der elektrischen Verbindung in einem Abstand L auf die zweite Schicht 4 gedrückt und die Schweißung vorgenommen.

**Patentansprüche**

1. Elektrische Verbindung eines elektrischen bandförmigen Leiters mit einer auf einem keramischen Substrat (1) angeordneten, Edelmetall aufweisenden Kontaktschicht (2), wobei die Dicke der Kontaktschicht (2) geringer ist als die Dicke des bandförmigen Leiters, dadurch gekennzeichnet, dass der bandförmige Leiter mindestens zwei Schichten (3; 4) unterschiedlicher Dicke und unterschiedlicher elektrischer spezifischer Widerstände aufweist und dass eine der Kontaktschicht (2) zugewandte erste Schicht (3) im Hinblick auf die weiteren Schichten ein Material mit dem niedrigsten elektrischen spezifischen Widerstand aufweist und dass die elektrische Verbindung zwischen dem bandförmigen Leiter und der Kontaktschicht (2) mittels Spaltschweißen gebildet ist.

2. Elektrische Verbindung nach Anspruch 1, dadurch gekennzeichnet, dass der bandförmige Leiter eine Anzahl an Schichten $n \geq 2$ aufweist und dass eine Ausbildung der Schichten (3; 4) sowie eine Anordnung und Ausbildung von Schweißelektroden (5; 6) beim Spaltschweißen den Gleichungen

$$(1) \quad 2 * \sum_{i=2}^{n} \frac{\rho_i * d_i}{k} + \frac{\rho_1 * L}{d_1} = m \cdot R_{2\equiv n}$$

$$(2) \quad R_{2\equiv 2} = \frac{\rho_2 * L}{d_2} \quad \text{für n=2}$$

$$(3) \quad R_{2\equiv n} = \left(\left(\frac{\rho_n * L}{d_n}\right)^{-1} + \left(\frac{2 * \rho_n * d_n}{k} + R_{2\equiv(n-1)}\right)^{-1}\right)^{-1} \quad \text{für n >2}$$

folgen und dass m eine Zahl im Bereich von 0 bis 10 ist, mit

L = Abstand zwischen den Schweißelektroden,
k = Breite der Schweißelektroden, wobei diese eine Länge von 1 aufweisen,
$\rho_1$ = elektrischer spezifischer Widerstand der ersten Schicht,
$\rho_n$ = elektrischer spezifischer Widerstand der n-ten Schicht,
$d_1$ = Dicke der ersten Schicht,
$d_n$ = Dicke der n-ten Schicht
$R_{2\equiv n}$ = elektrischer Widerstand der Schichten 2 bis n, gemessen zwischen den Schweißelektroden.

3. Elektrische Verbindung nach Anspruch 2, dadurch gekennzeichnet, dass der bandförmige Leiter eine erste Schicht (3) und eine zweite Schicht (4) aufweist ( n = 2 ) und dass eine Ausbildung der Schichten (3; 4) sowie eine Anordnung und Ausbildung der Schweißelektroden (5: 6) den Gleichungen

$$(1a) \quad 2 * \sum_{i=2}^{2} \frac{\rho_i * d_i}{k} + \frac{\rho_1 * L}{d_1} = m \cdot R_{2\equiv 2}$$

$$(2) \quad R_{2\equiv 2} = \frac{\rho_2 * L}{d_2}$$

$$(4) \quad \frac{2 * d_2^2}{L * k} + \frac{\rho_1 * d_2}{\rho_2 * d_1} = m$$

folgen und dass m eine Zahl im Bereich von 0 bis 10 ist, mit

L = Abstand zwischen den Schweißelektroden,
k = Breite der Schweißelektroden, wobei diese eine Länge von 1 aufweisen,

$\rho_1$ = elektrischer spezifischer Widerstand der ersten Schicht,

$\rho_2$ = elektrischer spezifischer Widerstand der zweiten Schicht,

$d_1$ = Dicke der ersten Schicht,

$d_2$ = Dicke der zweiten Schicht

$R_{2\equiv2}$ = elektrischer Widerstand der Schicht 2, gemessen zwischen den Schweißelektroden.

**4.** Elektrische Verbindung nach Anspruch 2, dadurch gekennzeichnet, dass der bandförmige Leiter eine erste, eine zweite und eine dritte Schicht aufweist ( n = 3 ) und dass eine Ausbildung der Schichten sowie eine Anordnung und Ausbildung der Schweißelektroden (5; 6) den Gleichungen

$$\text{(1b)} \quad 2 * \sum_{i=2}^{3} \frac{\rho_i * d_i}{k} + \frac{\rho_1 * L}{d_1} = m \cdot R_{2\equiv3}$$

$$\text{(3a)} \quad R_{2\equiv3} = \left( \left( \frac{\rho_3 * L}{d_3} \right)^{-1} + \left( \frac{2 * \rho_3 * d_3}{k} + R_{2\equiv2} \right)^{-1} \right)^{-1}$$

folgen und dass m eine Zahl im Bereich von 0 bis 10 ist, mit

L = Abstand zwischen den Schweißelektroden,

k = Breite der Schweißelektroden, wobei diese eine Länge von 1 aufweisen,

$\rho_1$ = elektrischer spezifischer Widerstand der ersten Schicht,

$\rho_2$ = elektrischer spezifischer Widerstand der zweiten Schicht,

$\rho_3$ = elektrischer spezifischer Widerstand der dritten Schicht,

$d_1$ = Dicke der ersten Schicht,

$d_2$ = Dicke der zweiten Schicht,

$d_3$ = Dicke der dritten Schicht,

$R_{2\equiv3}$ = elektrischer Widerstand der Schichten 2 bis 3, gemessen zwischen den Schweißelektroden.

**5.** Elektrische Verbindung nach Anspruch 2, dadurch gekennzeichnet, dass der bandförmige Leiter eine erste, eine zweite, eine dritte und eine vierte Schicht aufweist ( n = 4 ) und dass eine Ausbildung der Schichten sowie eine Anordnung und Ausbildung der Schweißelektroden (5; 6) den Gleichungen

$$\text{(1c)} \quad 2 * \sum_{i=2}^{4} \frac{\rho_i * d_i}{k} + \frac{\rho_1 * L}{d_1} = m \cdot R_{2\equiv4}$$

$$\text{(3b)} \quad R_{2\equiv4} = \left( \left( \frac{\rho_4 * L}{d_4} \right)^{-1} + \left( \frac{2 * \rho_4 * d_4}{k} + R_{2\equiv3} \right)^{-1} \right)^{-1}$$

folgen und dass m eine Zahl im Bereich von 0 bis 10 ist, mit

L = Abstand zwischen den Schweißelektroden,

k = Breite der Schweißelektroden, wobei diese eine Länge von aufweisen,

$\rho_1$ = elektrischer spezifischer Widerstand der ersten Schicht,

$\rho_2$ = elektrischer spezifischer Widerstand der zweiten Schicht,

$\rho_3$ = elektrischer spezifischer Widerstand der dritten Schicht,

$\rho_4$ = elektrischer spezifischer Widerstand der vierten Schicht,

$d_1$ = Dicke der ersten Schicht,

$d_2$ = Dicke der zweiten Schicht

$d_3$ = Dicke der dritten Schicht,

$d_4$ = Dicke der vierten Schicht

$R_{2\equiv4}$ = elektrischer Widerstand der Schichten 2 bis 4, gemessen zwischen den Schweißelektroden.

**6.** Elektrische Verbindung nach mindestens einem der Ansprüche 2 bis 5, dadurch gekennzeichnet, dass m eine Zahl im Bereich von 0 bis 1 ist.

**7.** Elektrische Verbindung nach mindestens einem der Ansprüche 1 bis 6, dadurch gekennzeichnet, dass das Verhältnis der Dicken zwischen der ersten Schicht (3) und der Summe der weiteren Schichten von 1:1,1 bis 1:30 beträgt.

**8.** Elektrische Verbindung nach mindestens einem der Ansprüche 1 bis 7, dadurch gekennzeichnet, dass das Verhältnis der Dicken zwischen der ersten Schicht (3) und der Summe der weiteren Schichten 1:10 beträgt.

**9.** Elektrische Verbindung nach mindestens einem der Ansprüche 1 bis 8, dadurch gekennzeichnet, dass die weiteren Schichten jeweils einen um den Faktor 2 bis 10 höheren elektrischen spezifischen Widerstand aufweisen als die erste Schicht (3).

**10.** Elektrische Verbindung nach Anspruch 9, dadurch gekennzeichnet, dass der Faktor 3 ist.

**11.** Elektrische Verbindung nach mindestens einem der Ansprüche 1 bis 10, dadurch gekennzeichnet, dass die erste Schicht (3) aus einem Edelmetall oder einer Edelmetall-Legierung gebildet ist.

**12.** Elektrische Verbindung nach Anspruch 11, dadurch gekennzeichnet, dass die erste Schicht (3) aus Gold oder Silber oder Kupfer oder aus einer mindestens eines dieser Elemente umfassenden niederohmigen Legierung gebildet ist.

**13.** Elektrische Verbindung nach mindestens einem der Ansprüche 1 bis 12, dadurch gekennzeichnet, dass mindestens eine der weiteren Schichten aus temperaturbeständigem Edelstahl oder einer hochohmigen Nickel-Legierung gebildet ist.

**14.** Elektrische Verbindung nach Anspruch 13, dadurch gekennzeichnet, dass mindestens eine der weiteren Schichten aus einer Kupfer-Nickel-Legierung oder einem Edelstahl der Klasse 1.4762 oder 1.4828 oder 1.4841 oder aus Inconel 600 oder Inconel 601 gebildet ist.

**15.** Verfahren zur Herstellung einer elektrischen Verbindung nach mindestens einem der Ansprüche 1 bis 14, dadurch gekennzeichnet, dass

a) der elektrische bandförmige Leiter der Gesamtdicke D mit der ersten Schicht auf die Kontaktschicht aufgelegt wird, und dass
b) zwei Schweißelektroden jeweils mit der Breite k und der Länge 1 in einem Abstand L zwischen den Schweißelektroden zueinander parallel angeordnet werden, und dass
c) die zwei Schweißelektroden in Höhe der Kontaktschicht gleichzeitig auf der Seite des bandförmigen Leiters aufgesetzt werden, die der ersten Schicht abgewandt ist, und dass
d) zwischen den zwei Schweißelektroden ein elektrischer Strom erzeugt wird, und dass
e) der elektrische Strom ausgehend von einer Schweißelektrode im wesentlichen einen Pfad wählt, der zuerst senkrecht gerichtet bis zum Erreichen der ersten Schicht verläuft, anschließend horizontal in Höhe der ersten Schicht und der Kontaktschicht und schließlich wieder senkrecht gerichtet in Richtung der anderen Schweißelektrode verläuft, und dass
f) dadurch eine Schweißverbindung zwischen der ersten Schicht und der Kontaktschicht erzeugt wird.

**16.** Verfahren nach Anspruch 15, dadurch gekennzeichnet, dass der Abstand L zwischen den Schweißelektroden mindestens doppelt so groß wie die Dicke D des bandförmigen Leiters ausgebildet wird.

**17.** Verfahren nach mindestens einem der Ansprüche 15 bis 16, dadurch gekennzeichnet, dass während des Schweißens der elektrische Strom oder die elektrische Spannung oder die elektrische Leistung konstant gehalten wird.

**18.** Verwendung der elektrischen Verbindung nach mindestens einem der Ansprüche 1 bis 14 zum Anschluss eines Sensors in einem Kraftfahrzeug, insbesondere für einen thermisch belasteten Sensor in der Abgasführung des Kraftfahrzeuges.

EP 1 126 546 A2

**Fig. 1**